# EUROPEAN PATENT APPLICATION

(11) **EP 4 518 596 A1**
(43) Date of publication of application: **05.03.2025**
(21) Application number: 23861933.2
(22) Date of filing: 06.06.2023
(51) Int. Cl.: H05K 7/14

(54) **SERVER AND CABINET SERVER**

(30) Priority: 05.09.2022 CN 202211079381
(71) Applicant: xFusion Digital Technologies Co., Ltd., Zhengzhou, Henan 450000 (CN)
(72) Inventor: JI, Zhongli, Zhengzhou, Henan 450000 (CN)
(74) Representative: MERH-IP Matias Erny Reichl Hoffmann Patentanwälte PartG mbB
(86) International application number: PCT/CN2023/098502
(87) International publication number: WO 2024/051230

(57) **Abstract**

Embodiments of this application provide a server and a cabinet server. The server includes at least one mainboard, at least one adapter board, at least one processor, and at least one memory board. Both the adapter board and the processor are disposed on the mainboard, the adapter board is disposed vertically or obliquely relative to the mainboard, the memory board is electrically connected to the adapter board, and the memory board extends from the adapter board to an outer side of the adapter board. The server in the embodiments of this application can improve space utilization in the server, and reduce a height of the server.

## Description

This application claims priority to Chinese Patent Application No. 202211079381.8, filed with the China National Intellectual Property Administration on September 5, 2022 and entitled "SERVER AND CABINET SERVER", which is incorporated herein by reference in its entirety.

### TECHNICAL FIELD

This application relates to the field of server technologies, and in particular, to a server and a cabinet server.

### BACKGROUND

With the rise of big data, cloud computing, and AI (Artificial intelligence, artificial intelligence), needs for computing power density of a server are increasingly high.

A cabinet server includes a cabinet body and a plurality of servers. The plurality of servers are horizontally spaced apart in a height direction of the cabinet body. The server includes a mainboard, a memory board and an XPU (X Processing Unit, various processors). The memory board is vertically inserted into the mainboard. A height of the memory board determines a maximum height of the server. A higher height of the server leads to a smaller quantity of servers accommodated in the cabinet server and lower computing density of the cabinet server.

However, in the foregoing manner of disposing the memory board in the server, space utilization in the server is low, and the height of the server is high.

### SUMMARY

Embodiments of this application provide a server and a cabinet server, so that space utilization in the server can be improved, and a height of the server can be reduced.

A first aspect of the embodiments of this application provides a server, including at least one mainboard, at least one adapter board, at least one processor, and at least one memory board. Both the adapter board and the processor are disposed on the mainboard, the adapter board is inclined relative to the mainboard, the memory board is electrically connected to the adapter board, and the memory board extends from the adapter board to an outer side of the adapter board.

According to the server provided in this embodiment of this application, the mainboard, the memory board, and the adapter board are disposed, the adapter board is disposed on the mainboard, and the adapter board is electrically connected to the mainboard, the memory board is disposed on the adapter board and is electrically connected to the adapter board. Therefore, the memory board can be electrically connected to the mainboard by using the adapter board. The adapter board is disposed vertically or obliquely relative to the mainboard. In other words, the adapter board is not parallel to the mainboard. The adapter board generally extends in a height direction of the server, and the memory board extends from the adapter board to a side of the adapter board. There is also an included angle between an extension direction of the memory board and an extension direction of the adapter board. The memory board generally extends in the length direction or a width direction of the server. Therefore, more memory boards can be arranged in space above the mainboard, to improve space utilization. In addition, the height of the server is determined by a height of the adapter board, and the height of the adapter board is usually less than a height of the memory board. Therefore, the height of the server can be reduced by disposing the adapter board, so that more servers can be accommodated in a cabinet server of a same height, thereby improving computing power density of the cabinet server.

In a possible implementation, in the server provided in this embodiment of this application, the adapter board is vertically disposed on the mainboard, the memory board is vertically disposed on the adapter board, and the mainboard is parallel to the memory board, so that it is convenient to insert the adapter board into the mainboard and insert a memory into the adapter board, and space utilization in the processor is further improved.

In a possible implementation, in the server provided in this embodiment of this application, at least two memory boards are successively spaced apart in a height direction of the adapter board. Therefore, heat dissipation space can be reserved between the memory boards, and the memory boards are laid out neatly.

In a possible implementation, in the server provided in this embodiment of this application, the processor is located at a middle position on the mainboard, the adapter board is located at a position that is on the mainboard and that is near the processor, and the memory board is located on a side that is of the adapter board and that is away from the processor; or the adapter board is located at an edge position on the mainboard, and the memory board is located on a side that is of the adapter board and that faces the processor. In both of the two disposing manners, the memory board and the processor occupy different space above the mainboard, and the memory board and the adapter board do not interfere with each other.

In a possible implementation, in the server provided in this embodiment of this application, there are at least two adapter boards, and each the adapter board is located on different sides of the processor. The memory board is electrically connected to the mainboard by using the adapter board. Therefore, a quantity of memory boards in the server can be increased by increasing a quantity of adapter boards, to further increase the computing power density of the server.

In a possible implementation, in the server provided in this embodiment of this application, at least two mainboards are disposed in parallel, and at least one processor is disposed on each of opposite surfaces of the at least two mainboards. The processor is disposed on the mainboard. Therefore, a quantity of processors disposed on the mainboard can be increased by increasing a quantity of mainboards, to further increase the computing power density of the server. In addition, processors on two mainboards are disposed opposite to each other, so that the processors can occupy space between the two mainboards, and the height of the server is not additionally increased.

In a possible implementation, in the server provided in this embodiment of this application, the at least one mainboard includes a first mainboard and a second mainboard, and the adapter board extends from the first mainboard to the second mainboard. The first mainboard and the second mainboard are electrically connected by using the adapter board. Therefore, a processor on the first mainboard and a processor on the second mainboard may also be electrically connected by using the adapter board, to implement communication between the processor on the first mainboard and the processor on the second mainboard.

In a possible implementation, in the server provided in this embodiment of this application, the server further includes at least one connector, the at least one mainboard includes the first mainboard and the second mainboard, the at least one adapter board includes a first adapter board and a second adapter board, one end of the first adapter board is connected to the first mainboard, one end of the second adapter board is connected to the second mainboard, and the other end of the first adapter board is connected to the other end of the second adapter board by using the connector. The first adapter board and the second adapter board are connected by using the connector, so that the following problem can be resolved: When the first mainboard and the second mainboard are connected by using an adapter board, the adapter board is deformed when an insertion part on the first mainboard and an insertion part on the second mainboard are misaligned.

In a possible implementation, in the server provided in this embodiment of this application, the connector is one of a flexible circuit board, a flat cable, or a cable. One of the flexible circuit board, the flat cable, or the cable is used as the connector, a position tolerance generated when the first adapter board and the second adapter board are misaligned can be compensated for.

A second aspect of the embodiments of this application provides a cabinet server, including a cabinet body and the server provided in the first aspect and mounted in the cabinet body.

With reference to the accompanying drawings, these and other aspects, implementations, and advantages of example embodiments are to become apparent from the embodiments described below. However, it should be understood that the specification and the accompanying drawings are for illustration only and are not intended to define limitations on this application. For details, refer to the appended claims. Other aspects and advantages of this application are set forth in the following descriptions, and are partly apparent from the descriptions, or are learned through practice of this application. In addition, aspects and advantages of this application may be implemented and obtained by using means and combinations specifically noted in the appended claims.

### BRIEF DESCRIPTION OF DRAWINGS

FIG. 1 is a schematic diagram of a structure of a data center according to an embodiment of this application;
FIG. 2 is a schematic diagram of a cabinet server according to an embodiment of this application;
FIG. 3 is a schematic diagram of an internal structure of a server in a related technology;
FIG. 4 is a schematic diagram of a first internal structure of a server according to an embodiment of this application;
FIG. 5 is a schematic diagram 1 of positions of an adapter board and a mainboard in a server according to an embodiment of this application;
FIG. 6 is a schematic diagram 2 of positions of an adapter board and a mainboard in a server according to an embodiment of this application;
FIG. 7 is a diagram of a connection between an adapter board and a mainboard in a server according to an embodiment of this application;
FIG. 8 is a diagram of a connection between a memory board and an adapter board in a server according to an embodiment of this application;
FIG. 9 is a schematic diagram of a second internal structure of a server according to an embodiment of this application;
FIG. 10 is a diagram of a connection between a processor and a mainboard in a server according to an embodiment of this application;
FIG. 11 is a diagram of a first layout of an adapter board and a processor in a server according to an embodiment of this application;
FIG. 12 is a diagram of a second layout of an adapter board and a processor in a server according to an embodiment of this application;
FIG. 13 is a diagram of a third layout of an adapter board and a processor in a server according to an embodiment of this application;
FIG. 14 is a schematic diagram of a third internal structure of a server according to an embodiment of this application;
FIG. 15 is a schematic diagram of a structure of a cold plate in FIG. 14;
FIG. 16 is a diagram of a cooling state of the server in FIG. 14;
FIG. 17 is a schematic diagram of another structure of a data center according to an embodiment of this application;
FIG. 18 is a schematic diagram of a fourth internal structure of a server according to an embodiment of this application;
FIG. 19 is a diagram of a cooling state of the server in FIG. 18;
FIG. 20 is a schematic diagram of a fifth internal structure of a server according to an embodiment of this application;
FIG. 21 is a diagram of a cooling state of the server in FIG. 20;
FIG. 22 is a schematic diagram of a sixth internal structure of a server according to an embodiment of this application;
FIG. 23 is a diagram of a connection of an adapter board in FIG. 22 with a first mainboard and a second mainboard;
FIG. 24 is a top view of FIG. 22;
FIG. 25 is a schematic diagram of a seventh internal structure of a server according to an embodiment of this application;
FIG. 26 is a schematic diagram of an eighth internal structure of a server according to an embodiment of this application; and
FIG. 27 is a schematic diagram of a ninth internal structure of a server according to an embodiment of this application.

Description of reference numerals:
10: Data center;
100: Equipment room; 110: Coolant storage apparatus; 111: Liquid inlet pipe; 1111: Main liquid inlet pipe; 1112: Liquid inlet sub-pipe; 112: Liquid outlet pipe; 1121: Main liquid outlet pipe; 1122: Liquid outlet sub-pipe; 120: Air conditioner;
200: Cabinet server;
210: Cabinet body; 211: Cabinet entrance; 212: Cabinet exit; 213: Cavity;
220 and 220a: Server; 221 and 221a: Housing; 2211 and 2211a: Accommodating cavity; 2212: Housing entrance; 2213: Housing exit; 222 and 222a: Mainboard; 2221: First mainboard; 2222: Second mainboard; 223 and 223a: Processor; 224 and 224a: Memory board; 2241: First memory board; 2242: Second memory board; 225 and 225a: Base; 226a: Air cooling heat dissipation member; 227: Adapter board; 2271: First adapter board; 2272: Second adapter board; 2273: Connector; 228: Heat sink; 229: Cold plate; 2291: Metal plate; 2292: Channel; 2292a: Channel entrance; 2292b: Channel exit;
H1: Server height;
H2: Memory board height;
H3: Relative height of an adapter board;
J1: First insertion part;
J2: Second insertion part;
J3: Third insertion part;
J4: Fourth insertion part;
X: First direction;
Y: Second direction;
Z: Third direction.

### DESCRIPTION OF EMBODIMENTS

Terms used in implementations of this application are merely used to explain specific embodiments of this application, and are not intended to limit this application. Implementations of embodiments of this application are described in detail below with reference to the accompanying drawings.

For ease of understanding, related technical terms in embodiments of this application are first explained and described.

Processor: A processor is a general name of various processors such as a CPU (Central Processing Unit, central processing unit), a GPU (Graphics Processing Unit, graphics processing unit), or a TPU (Tensor Processing Unit, tensor processing unit), and is referred to as an XPU for short.

Memory board: A memory board is configured to temporarily store operation data of a processor and data exchanged with an external memory such as a hard disk. The processor invokes data that needs to be operated into a memory to perform an operation. After the operation is completed, the processor transmits a result.

Cold plate: A cold plate is a sealed heat sink that can accommodate flowing liquid, and is usually bonded to a heat emitting element by using a thermal interface material, to take away heat from the heat emitting element.

Immersive liquid cooling: A heated electronic component is immersed in a refrigerant (coolant), and heat is taken away through flowing and circulation of liquid. When immersive liquid cooling is used, the heat emitting element is in direct contact with the refrigerant in an omnidirectional manner. Therefore, heat dissipation efficiency of immersive liquid cooling is higher.

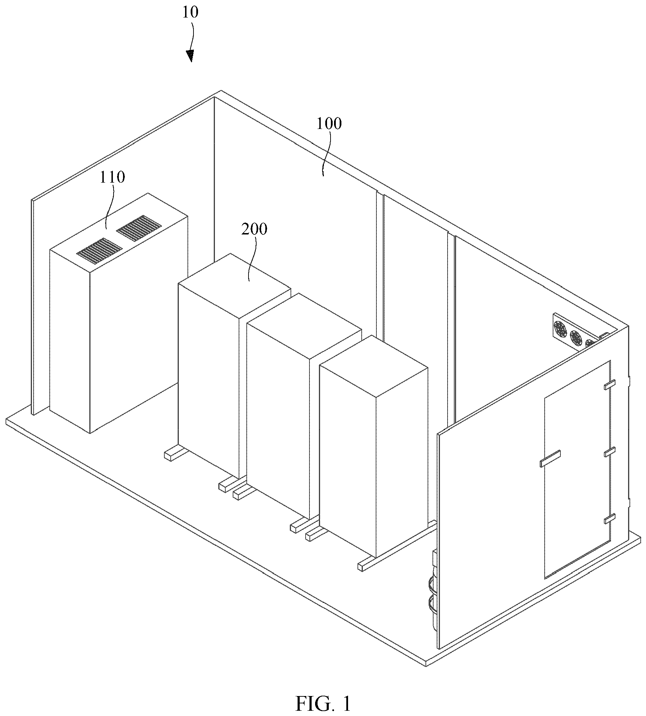

FIG. 1 is a schematic diagram of a structure of a data center according to an embodiment of this application. As shown in FIG. 1, a data center 10 is a globally coordinated network of specific devices, and is used to transfer, accelerate, display, compute, and store data information on an Internet infrastructure. The data center 10 provided in this embodiment of this application may include an equipment room 100 and at least one cabinet server 200 disposed in the equipment room 100. It may be understood that the equipment room 100 may be a closed room, or may be a room that is open on one or more sides. The room 100 may be a constructed temporary room, such as a tent room or a board room, or may be a constructed permanent room.

Only one cabinet server 200 or a plurality of cabinet servers 200 may be disposed in the equipment room 100. When a plurality of cabinet servers 200 are disposed in the equipment room 100, the cabinet servers 200 may be the same, partially the same, or different. The cabinet server 200 may be of various types, such as a desktop server, a blade server, a rack server, a high-density server, and an XPU server.

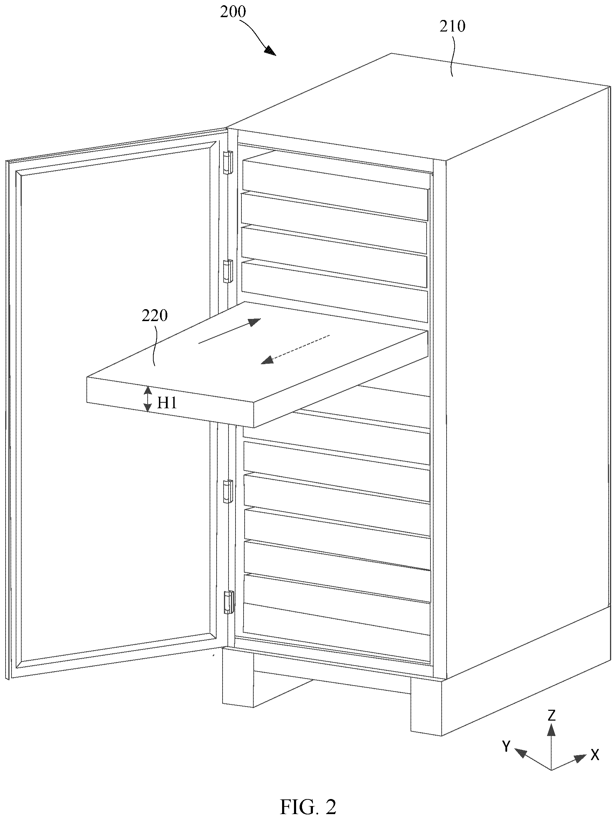

FIG. 2 is a schematic diagram of the cabinet server according to an embodiment of this application. As shown in FIG. 2, the cabinet server 200 provided in this embodiment of this application may be a rack server. The cabinet server 200 includes a cabinet body 210 and a plurality of servers 220 mounted in the cabinet body 210. The cabinet body 210 is used as a support component of the server 220. Specifically, still as shown in FIG. 2, a width direction of the cabinet body 210 is referred to as a first direction X, a length direction of the cabinet body 210 is referred to as a second direction Y, a height direction of the cabinet body 210 is referred to as a third direction Z, and the plurality of servers 220 are successively spaced apart in the cabinet body in the third direction Z.

A height direction of the server 220 is consistent with the third direction Z, a height of the server 220 is referred to as a server height H1, and the server height H1 is usually a standard IU or 2U (where U is a unit representing an external size of an electronic device, and is an abbreviation of unit, and 1U is equal to 48.26 cm). The smaller the server height H1 , the more servers 220 can be accommodated in a cabinet body 210 of a same height, and therefore, larger computing power density of the cabinet server 200.

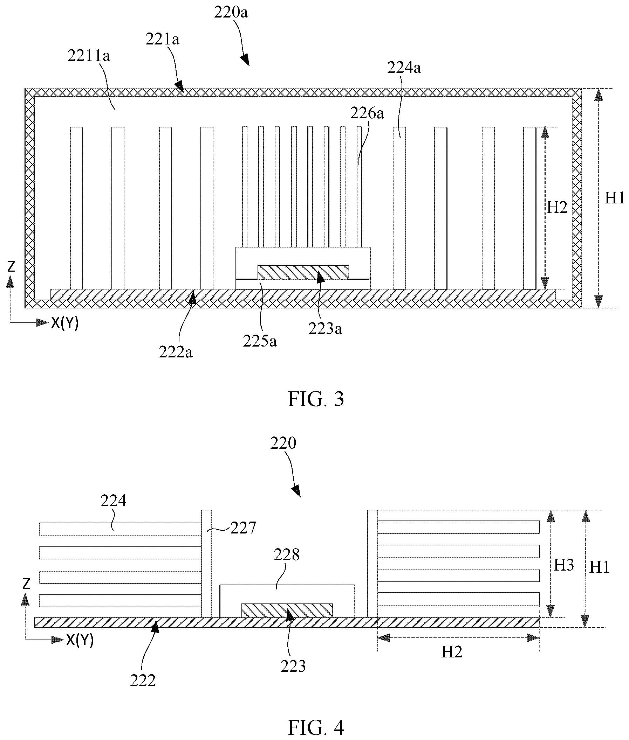

FIG. 3 is a schematic diagram of an internal structure of a server in a related technology. In the related technology, the server is represented by 220a, and all components in the server 220a are also distinguished by adding a suffix a. As shown in FIG. 3, the server 220a includes a housing 221a, a mainboard 222a, at least one processor 223a, and a plurality of memory boards 224a. The housing 221a has an accommodating cavity 2211a for accommodating the mainboard 222a, the processor 223a, and the memory boards 224a, and a server height H1 is a height of the housing 221a.

The mainboard 222a is connected to an inner bottom wall of the housing 221a and is disposed in parallel to the inner bottom wall of the housing 221a. The processor 223a may be welded to the mainboard by using a base 225a.

A plurality of memory slots may be welded on a peripheral side of the processor 223a on the mainboard 222a. The memory board 224a is inserted into the memory slot to be electrically connected to the mainboard 222a. An extension direction of the memory board 224a is the same as a third direction Z. A dimension of the memory board 224a in the third direction Z is referred to as a memory board height H2, and the memory board height H2 determines a value of the server height H1. Because the memory board height H2 is generally large, a server height H1 of a single server 220a is generally large, so that, a quantity of servers 220a accommodated in a cabinet body 210 of a same height is relatively small, and computing power density of the cabinet server 200 is relatively small.

In addition, the data center 10 may be a data center using air cooling heat dissipation. An air conditioner is disposed in the data center 10, and heat generated by the cabinet server 200 is taken away by cold air of the air conditioner. An amount of heat dissipated by the processor 223a in the server 220a is relatively large, and an air cooling heat dissipation member 226a is further disposed on the processor 223a. To increase cold air flow on the processor 223a, the air cooling heat dissipation member 226a is generally in a fin structure shown in FIG. 3. A dimension of the fin structure in the third direction Z is relatively large, and this also leads to an increase in the server height H1.

FIG. 4 is a schematic diagram of a first internal structure of the server according to an embodiment of this application. As shown in FIG. 4, in this embodiment of this application, the server 220 includes at least one mainboard 222, at least one adapter board 227, at least one processor 223, and at least one memory board 224. Both the adapter board 227 and the processor 223 are disposed on the mainboard 222, and the adapter board 227 is disposed obliquely or vertically relative to the mainboard 222, the memory board 224 is electrically connected to the adapter board 227, and the memory board 224 extends from the adapter board 227 toward an outer side of the adapter board 227. In this embodiment, the outer side of the adapter board 227 may include a side that is of the adapter board 227 and that is away from the processor 223 and/or a side that is of the adapter board 227 and that faces the processor 223.

An extension direction of the mainboard 222 is consistent with the first direction X or the second direction Y in FIG. 4. The processor 223 is disposed on the mainboard 222 and is electrically connected to the mainboard 222. The mainboard 222 is further electrically connected to another electronic component such as a resistor, a capacitor, or a sensor. To facilitate an electrical connection between the processor 223 and the another electronic component on the mainboard 222, the processor 223 is usually disposed in a middle area of the mainboard 222. The processor 223 is a core working component used by the server 220 to perform an operation, and the processor 223 cooperates with the another electronic component on the mainboard 222. A large amount of heat is generated when the processor 223 works. Therefore, a heat sink 228 covers the processor 223, to transfer the heat generated when the processor 223 works.

The adapter board 227 is disposed on the mainboard 222 and is electrically connected to the mainboard 222, and the memory board 224 is electrically connected to the adapter board 227. Therefore, the memory board 224 is electrically connected to the mainboard 222 by using the adapter board 227.

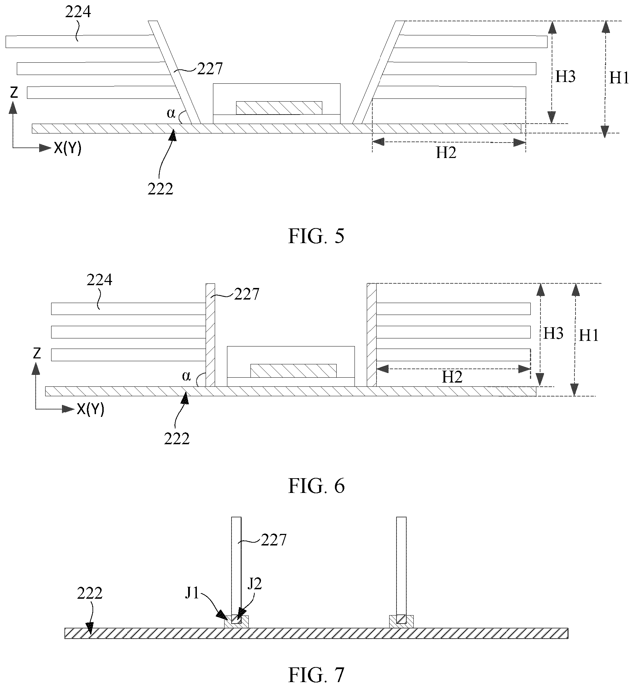

FIG. 5 is a schematic diagram 1 of positions of the adapter board and the mainboard in the server according to an embodiment of this application. FIG. 6 is a schematic diagram 2 of positions of the adapter board and the mainboard in the server according to an embodiment of this application. To facilitate annotation of an included angle α, some adapter boards are removed. As shown in FIG. 5 and FIG. 6, there is the included angle α between the adapter board 227 and the mainboard 222. In FIG. 5, the included angle α between the adapter board 227 and the mainboard 222 is 45°. In FIG. 6, the included angle α between the adapter board 227 and the mainboard 222 is 90°. The included angle α may vary between 45° and 90°.

A dimension of the adapter board 227 in the third direction is referred to as a relative height H3 of the adapter board, and a smaller included angle α leads to a smaller relative height H3 of the adapter board and a smaller server angle H1. However, when the included angle α is less than 45°, it is inconvenient to insert the adapter board 227 into the mainboard 222, and the plurality of memory boards 224 connected to the adapter board 227 also occupy more space above the mainboard 222 in the first direction X (or the second direction Y) in FIG. 5. Therefore, the included angle α may vary between 45° and 90°.

A thickness of the mainboard 222 (a dimension of the mainboard in the third direction Z) is usually a determined value. Therefore, the server height H1 is determined by the relative height H3 of the adapter board. The memory board 224 extends toward a side of the adapter board 227. In other words, there is also an included angle between an extension direction of the memory board height H2 and an extension direction of the relative height H3 of the adapter board. Therefore, a larger quantity of memory boards 224 can be arranged in space above the mainboard 222, thereby improving space utilization.

Still as shown in FIG. 4 and FIG. 6, when the included angle between the adapter board 227 and the mainboard 222 is 90°, the extension direction of the relative height H3 of the adapter board is consistent with the third direction Z. In this case, a value of the relative height H3 of the adapter board is the largest in the third direction Z, and the relative height H3 of the adapter board is still far less than the memory board height H2 at the maximum value. Therefore, the server height H1 can be reduced by disposing the adapter board 227, so that more servers 220 can be accommodated in the cabinet server 200, thereby increasing the computing power density of the cabinet server 200.

Still as shown in FIG. 4, the adapter board 227 is vertically disposed on the mainboard 222, the memory board 224 is vertically disposed on the adapter board 227, and the mainboard 222 is parallel to the memory board 224.

FIG. 7 is a diagram of a connection between the adapter board and the mainboard in the server according to an embodiment of this application. As shown in FIG. 7, a first insertion part J1 is welded on the mainboard 222, and the first insertion part J1 may be a socket. A second insertion part J2 is disposed on an end that is of the adapter board 227 and that faces the mainboard 222, and the second insertion part J2 may be a pin. The second insertion part J2 is inserted into the first insertion part J1, to electrically connect the adapter board 227 to the mainboard 222. It may be understood that the first insertion part J1 may be alternatively a pin, and the second insertion part J2 is a socket. The adapter board 227 may be vertically disposed on the mainboard 222, so that the first insertion part J1 is inserted into the second insertion part J2.

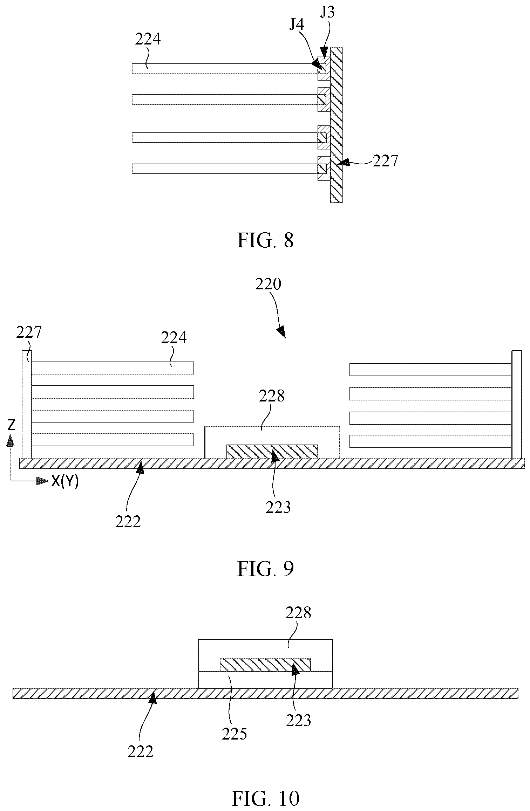

FIG. 8 is a diagram of a connection between the memory board and the adapter board in the server according to an embodiment of this application. As shown in FIG. 8, a plurality of third insertion parts J3 are welded on the adapter board 227, and the third insertion parts J3 may be sockets. A fourth insertion part J4 is disposed on an end that is of the memory board 224 and that faces the adapter board 227, and the fourth insertion part J4 may be a pin. The fourth insertion part J4 is inserted into the third insertion part J3, to electrically connect the memory board 224 to the adapter board 227. It may be understood that the third insertion part J3 may be alternatively a pin, and the fourth insertion part J4 is a socket. The memory board 224 is vertically disposed on the adapter board 227, so that the third insertion part J3 is inserted into the fourth insertion part J4. In addition, the memory board 224 further needs to be kept parallel to the mainboard 222 to make full use of the space above the mainboard 222.

To increase a data storage capability of the server 220, there are at least two memory boards 224, and the memory boards 224 are successively spaced apart in a height direction of the adapter board 227.

Based on different requirements of the server 220 for data storage capabilities, there may be two or more memory boards 224. The memory boards 224 are successively spaced apart in the extension direction of the relative height H3 of the adapter board, and the memory boards 224 are parallel to each other, so that the memory boards 224 make full use of the space above the mainboard 222 in FIG. 4.

FIG. 9 is a schematic diagram of a second internal structure of the server according to an embodiment of this application. As shown in FIG. 4 and FIG. 9, the processor 223 is located at a middle position on the mainboard 222. Based on different layouts of the mainboard 222, the adapter board 227 may be laid out on the mainboard 222 in different manners. Specifically, in the embodiment shown in FIG. 4, the adapter board 227 is located at a position that is on the mainboard 222 and that is near the processor 223, and the memory board 224 is located on a side that is of the adapter board 227 and that is away from the processor 223; and in the embodiment shown in FIG. 9, the adapter board 227 is located at an edge position on the mainboard in the first direction X (or the second direction Y) in FIG. 9, and the memory board 224 is located on a side that is of the adapter board and that faces the processor 223. In the foregoing two disposing manners, the memory board 224 and the processor 223 occupy different space above the mainboard 222. Therefore, the memory board 224 and the processor 223 do not interfere with each other.

FIG. 10 is a diagram of a connection between the processor and the mainboard in the server according to an embodiment of this application. As shown in FIG. 10, the server 220 further includes a base 225. The base 225 is disposed between the processor 223 and the mainboard 222, and the base 225 is used to support the processor 223. A surface that is of the base 225 and that faces the processor 223 is electrically connected to the processor 223, and a surface that is of the base 225 and that faces the mainboard 222 is electrically connected to the mainboard. Therefore, the processor 223 is electrically connected to the mainboard by using the base 225. Specifically, the processor 223 may be electrically connected to the base 225 in a die bonding manner, and the base 225 may be electrically connected to the mainboard 222 in a welding manner.

To connect to more memory boards 224, there are at least two adapter boards 227, and the adapter boards 227 are located on different sides of the processor 223.

There may be two or more adapter boards 227, for example, three or four. The processor 223 is usually rectangular, and the adapter boards 227 may be disposed on four peripheral sides of the processor 223. A layout manner of the adapter board 227 is different from a layout manner of the processor 223. A possible layout manner of the adapter board 227 and a possible layout manner of the processor 223 are described below.

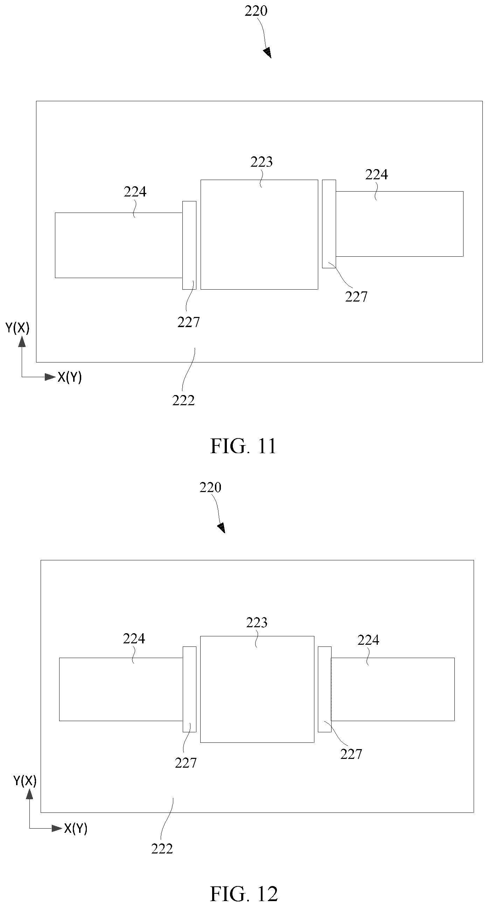

FIG. 11 is a diagram of a first layout of the adapter board and the processor in the server according to an embodiment of this application. As shown in FIG. 11, each the adapter board 227 is located on two opposite sides of the processor 223, and the adapter boards 227 on the two opposite sides of the processor 223 are disposed in a staggered manner.

Still as shown in FIG. 11, two adapter boards 227 and one processor 223 are disposed in the server 220, and the adapter boards 227 may be disposed in the first direction X (or the second direction Y) on both sides of the processor 223 in a staggered manner, to avoid another electronic component on the mainboard 222.

It may be understood that three adapter boards 227 may be disposed in the server 220, and the adapter boards 227 are separately disposed on three different sides of the processor 223, or two adapter boards 227 are disposed on a same side, the adapter boards 227 are specifically disposed based on a layout on the mainboard 222. Four adapter boards 227 may also be disposed in the server 220, and the adapter boards 227 are separately disposed on four different sides of the processor 223, or two adapter boards 227 are disposed on a same side, the adapter boards 227 are specifically disposed based on a layout on the mainboard 222.

FIG. 12 is a diagram of a second layout of the adapter board and the processor in the server according to an embodiment of this application. As shown in FIG. 12, a quantity of adapter boards 227 is an even number, and the adapter boards 227 are symmetric with respect to the processor 223.

Still as shown in FIG. 12, two adapter boards 227 and one processor 223 are disposed in the server 220, and the adapter boards 227 may be symmetrically disposed on both sides of the processor 223 in the first direction X (or the second direction Y), so that cabling on the mainboard 222 for electrically connecting the processor 223 and the adapter board 227 is facilitated.

four adapter boards 227 may also be disposed in the server 220, the adapter boards 227 are separately disposed on four different sides of the processor 223, and adapter boards 227 on two opposite sides are symmetric with respect to the processor 223.

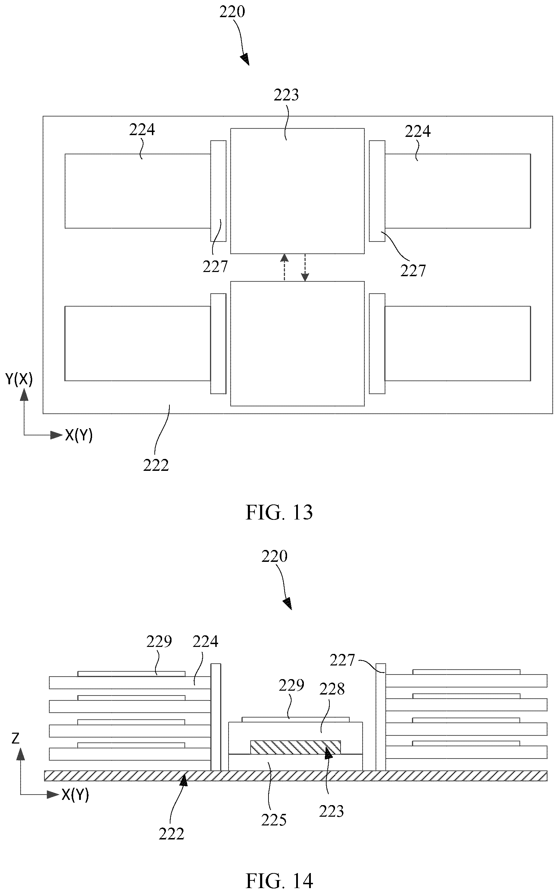

FIG. 13 is a diagram of a third layout of the adapter board and the processor in the server according to an embodiment of this application. As shown in FIG. 13, to increase a computing capability of the server 220, the server 220 may include two or more processors 223. The server 220 shown in FIG. 13 includes two processors 223, and both the two processors 223 are electrically connected to the mainboard 222. The two processors 223 may be electrically connected to each other by using cabling on the mainboard 222, to facilitate data transmission or backup between the processors 223.

Each processor 223 has a corresponding adapter board 227, and a layout manner of the adapter board 227 and the processor 223 is the same as the layout manner shown in FIG. 11 or FIG. 12. Details are not described herein again.

When the server 220 runs, a large amount of heat is emitted when the processor 223, the memory board 224, and another electronic component in the server 220 work. Accumulation of the heat leads to a rise in temperature of the server 220, and high temperature reduces performance of the processor 223, the memory board 224, and the another electronic component in the server 220, and consequently the server 220 cannot run normally. Therefore, effective heat dissipation measures are required to dissipate heat for the server 220, to reduce working temperature of each electronic component in the server 220. A possible heat dissipation manner of the server 220 is described below.

FIG. 14 is a schematic diagram of a third internal structure of the server according to an embodiment of this application. As shown in FIG. 14, based on the foregoing embodiment, the server 220 in this embodiment further includes a plurality of cold plates 229, and the cold plate 229 covers at least one of the memory board 224 and the heat sink 228. The cold plate 229 is configured to dissipate heat for a corresponding memory board 224 and a corresponding processor 223.

The cold plate 229 is a heat dissipation member made of a metal with good thermal conductivity. For example, the cold plate 229 may be an aluminum plate, a copper plate, or a copper aluminum alloy plate. To improve a cooling capability of the cold plate 229, the cold plate 229 further has a channel in which liquid flows. Heat emitted from the processor 223 and the memory board 224 is taken away by the flow of liquid in the channel of the cold plate 229. The cold plate 229 directly covers the heat sink 228 of the processor 223 or the memory board 224, and the cold plate 229 has flowing coolant. Therefore, cooling efficiency of the cold plate 229 is higher than that of the air cooling heat dissipation member 226a, so that space occupied by the cold plate 229 in the third direction Z is relatively small. In the related technology, a dimension of the air cooling heat dissipation member 226a in the fin structure in the third direction Z is relatively large, so that, the server height H1 is relatively large. In comparison, when cooling is performed by using the cold plate 229, the server height H1 is not increased.

A specific process of performing cooling by using the cold plate is described below.

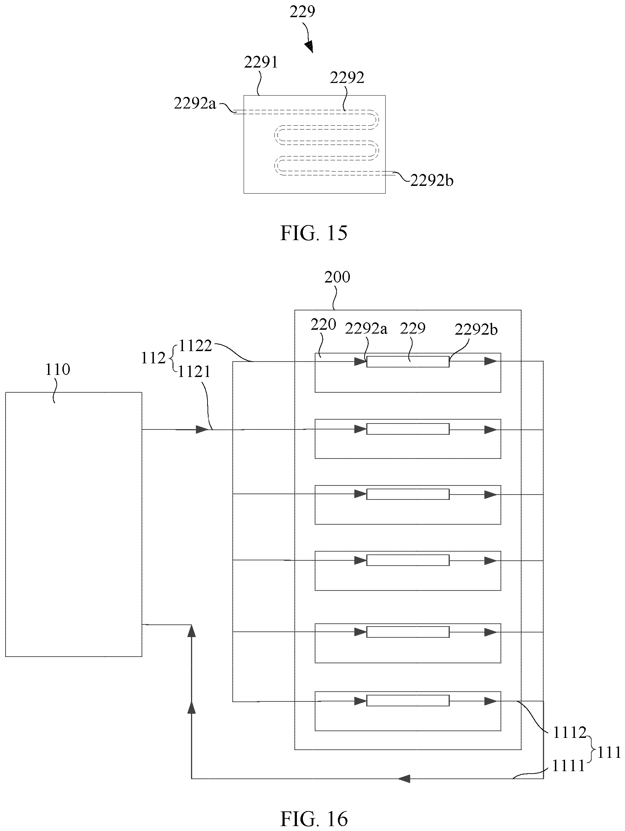

FIG. 15 is a schematic diagram of a structure of the cold plate in FIG. 14. As shown in FIG. 15, the cold plate 229 includes a metal plate 2291 and a channel 2292, and the channel 2292 has a channel entrance 2292a and a channel exit 2292b for entry and exit of coolant.

FIG. 16 is a diagram of a cooling state of the server in FIG. 14. As shown in FIG. 1 and FIG. 16, a coolant storage apparatus 110 is disposed in the equipment room 100. The coolant storage apparatus 110 includes a liquid inlet pipe 111 and a liquid outlet pipe 112. The liquid outlet pipe 112 includes a main liquid outlet pipe 1121 and a plurality of liquid outlet sub-pipes 1122, the main liquid outlet pipe 1121 is separately in communication with the plurality of liquid outlet sub-pipes 1122, and the liquid outlet sub-pipes 1122 are separately in communication with channel entrances 2292a of different cold plates 229. The liquid inlet pipe 111 includes a main liquid inlet pipe 1111 and a liquid inlet sub-pipe 1112, the main liquid inlet pipe 1111 is separately in communication with a plurality of liquid inlet sub-pipes 1112, and the liquid inlet sub-pipes 1112 are separately in communication with channel exits 2292b of different cold plates 229.

In FIG. 16, an arrow is used to indicate a flowing direction of coolant. As shown in FIG. 16, the coolant successively flows from the coolant storage apparatus 110 through the main liquid outlet pipe 1121, the liquid outlet sub-pipe 1122, the channel entrance 2292a of the cold plate 229, the channel 2292 in the cold plate 229, the channel exit 2292b of the cold plate 229, the liquid inlet sub-pipe 1112, and the main liquid inlet pipe 1111, and then returns to the coolant storage apparatus 110, so that heat of the memory board 224 and the processor 223 is taken away by the flow of the liquid in the channel 2292.

Each server 220 has a respective cooling loop. Therefore, when one of the servers 220 needs to be maintained, only a liquid outlet sub-pipe 1122 and a liquid inlet sub-pipe 1112 that are connected to the server 220 need to be turned off, and this does not affect normal running of another server 220.

In each server 220, a channel 2292 in a cold plate 229 on the processor 223 and a channel 2292 in a cold plate 229 on the memory board 224 may be connected in parallel. In a parallel connection manner, cooling efficiency of the processor 223 and the memory board 224 is relatively high.

In each server 220, a channel 2292 in a cold plate 229 on the processor 223 and a channel 2292 in a cold plate 229 on the memory board 224 may be connected in series. In a serial connection manner, an amount of used coolant can be reduced.

An amount of heat emitted by the memory board 224 is less than an amount of heat emitted by the processor 223. To further reduce cooling costs and simplify a structure of the server 220, the cold plate 229 may be disposed only on the processor 223, and the cold plate 229 is not disposed on the memory board 224. Heat of the memory board 224 is dissipated in an air cooling form.

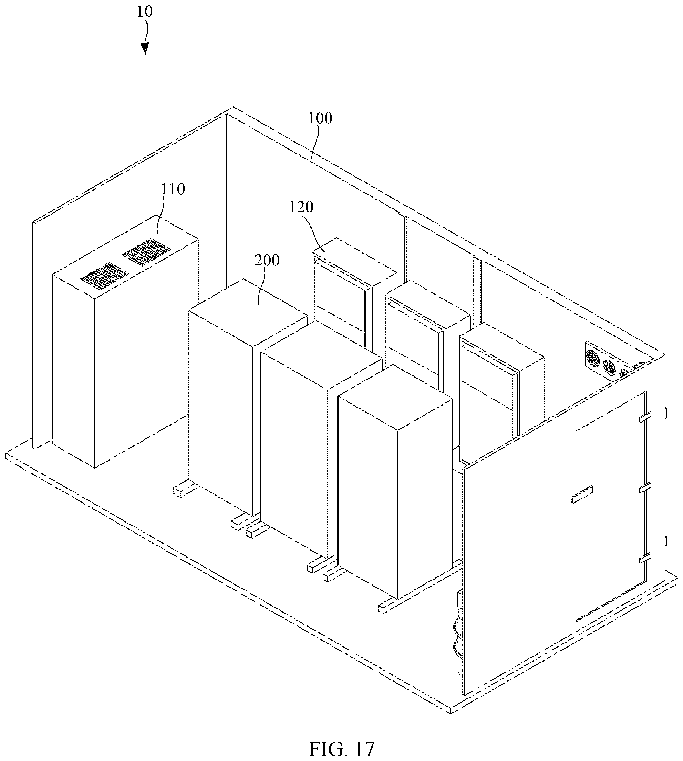

Specifically, FIG. 17 is a schematic diagram of another structure of the data center according to an embodiment of this application. As shown in FIG. 17, a plurality of air conditioners 120 are further disposed in the equipment room 100. A cavity formed in the cabinet body 210 is in communication with space in the equipment room 100, and temperature of the equipment room 100 is reduced by cold air of the air conditioners, so that heat generated by the memory board 228 is taken away.

It should be noted that when the cold plate 229 is used to perform cooling, because the coolant is not in direct contact with the component in the server 220, insulation and corrosion resistance of the coolant flowing in the cold plate do not need to be excessively fine, to reduce refrigeration costs of the server 220.

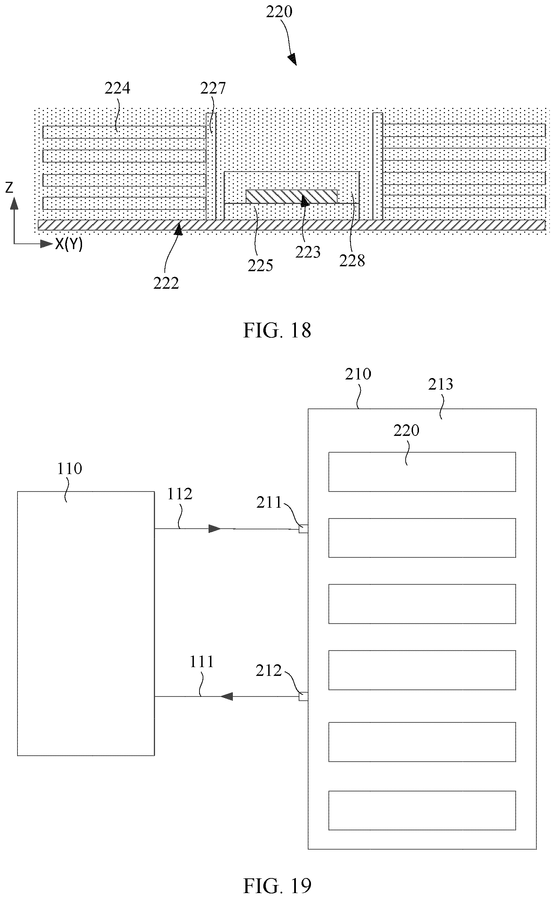

The server 220 may be alternatively cooled in an immersive liquid cooling manner. FIG. 18 is a schematic diagram of a fourth internal structure of the server according to an embodiment of this application. As shown in FIG. 18, the coolant is represented by dots, each server 220 is immersed in the coolant, and heat emitted by the processor 223 and the memory board 224 is taken away as the coolant flows. The coolant is characterized by insulation, corrosion resistance, non-flammability, nontoxicity, and the like. Therefore, the components in the server 220 are not damaged.

FIG. 19 is a diagram of a cooling state of the server in FIG. 18. As shown in FIG. 1 and FIG. 19, a coolant storage apparatus 110 is disposed in the equipment room 100, and a liquid inlet pipe 111 and a liquid outlet pipe 112 are disposed in the coolant storage apparatus 110. A cabinet body entrance 211 and a cabinet body exit 212 are disposed on the cabinet body 210, the cabinet body entrance 211 is in communication with the liquid outlet pipe 112, and the cabinet body exit 212 is in communication with the liquid inlet pipe 111. There is coolant in a cavity 213 formed in the cabinet body 210, and each server 220 is immersed in the coolant. In FIG. 19, an arrow is used to indicate a flowing direction of coolant. As shown in FIG. 19, the coolant successively flows from the coolant storage apparatus 110 through the liquid outlet pipe 112, the cabinet body entrance 211, the cavity 213, and the cabinet body exit 212, and flows from the liquid inlet pipe 111 into the coolant storage apparatus 110.

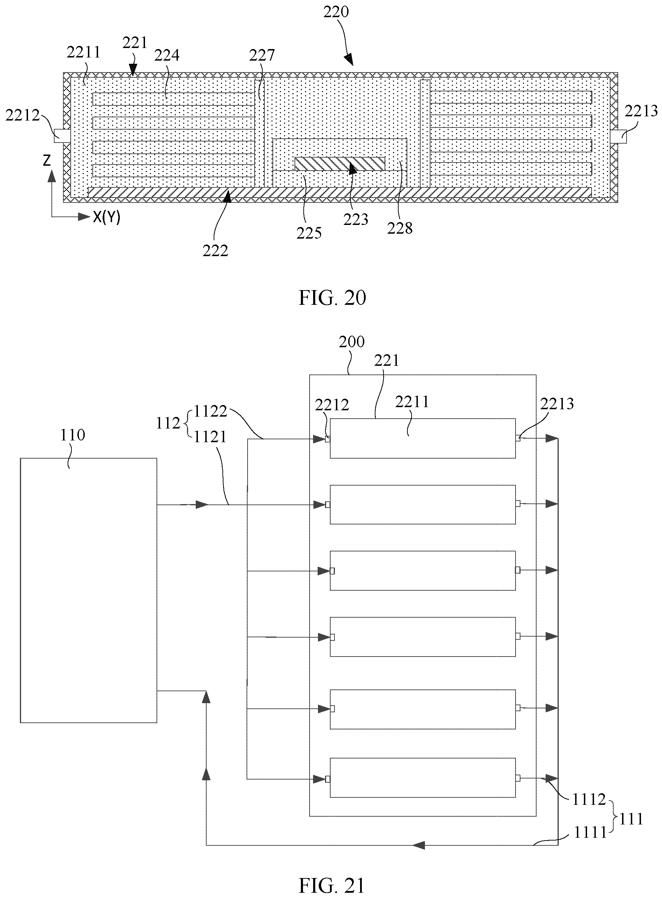

Overall immersion cooling on the cabinet server 200 is described above. In some embodiments, alternatively, immersion cooling may be separately performed on each server 220. FIG. 20 is a schematic diagram of a fifth internal structure of the server according to an embodiment of this application. As shown in FIG. 20, the server 220 further includes a housing 221, the housing 221 has an accommodating cavity 2211, the mainboard 222, the processor 223, the adapter board 227, and the memory board 224 are all located in the accommodating cavity 2211, and the mainboard 222 is connected to an inner wall of the housing 221.

The mainboard 222 may be connected to a sidewall of the housing 221 by using a fastener, so that the mainboard 222 is mounted in the accommodating cavity. Both the processor 223 and the adapter board 227 are connected to the mainboard 222, the memory board 224 is connected to the adapter board 227, and the processor 223, the adapter board 227, and the memory board 224 are all located in the accommodating cavity 2211.

There are a housing entrance 2212 and a housing exit 2213 for entry and exit of the coolant on the sidewall of the housing 221. Heat emitted when the processor 223 and the memory board 224 work is taken away by the flow of the coolant in the housing 221.

Specifically, FIG. 21 is a diagram of a cooling state of the server in FIG. 20. As shown in FIG. 1 and FIG. 21, a coolant storage apparatus 110 is disposed in the equipment room 100, and there are a liquid inlet pipe 111 and a liquid outlet pipe 112 on the coolant storage apparatus 110. The liquid outlet pipe 112 includes a main liquid outlet pipe 1121 and a plurality of liquid outlet sub-pipes 1122, the main liquid outlet pipe 1121 is separately in communication with the plurality of liquid outlet sub-pipes 1122, and the liquid outlet sub-pipes 1122 are separately in communication with different housing entrances 2212. The liquid inlet pipe 111 includes a main liquid inlet pipe 1111 and a liquid inlet sub-pipe 1112, the liquid inlet pipe 1111 is separately in communication with a plurality of liquid inlet sub-pipes 1112, and the liquid inlet sub-pipes 1112 are separately in communication with different housing exits 2213.

In FIG. 21, an arrow is used to indicate a flowing direction of coolant. As shown in FIG. 21, the coolant successively flows from the coolant storage apparatus 110 through the main liquid outlet pipe 1121, the liquid outlet sub-pipe 1122, the housing entrance 2212, the accommodating cavity 2211, the housing exit 2213, the liquid inlet sub-pipe 1112, and the main liquid inlet pipe 1111, and then returns to the coolant storage apparatus 110. Heat generated by each component in the server 220 is taken away by the flow of the coolant. In other words, each server 220 has a respective cooling loop. Therefore, when one of the servers 220 needs to be maintained, only a liquid outlet sub-pipe 1122 and a liquid inlet sub-pipe 1112 that are connected to the server 220 need to be turned off, and this does not affect normal running of another server 220.

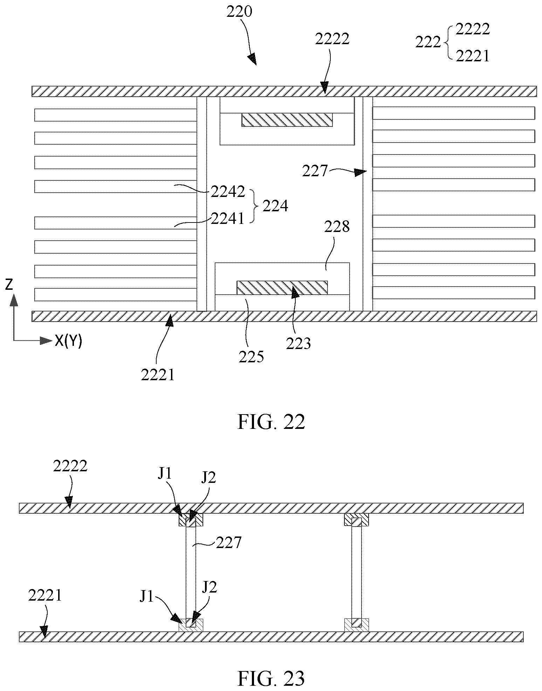

To increase a computing capability of the server 220, two mainboards 222 may be alternatively disposed in the server 220. FIG. 22 is a schematic diagram of a sixth internal structure of the server according to an embodiment of this application. As shown in FIG. 22, there are two mainboards 222, the adapter board 227 is connected between the two mainboards, there are at least two processors 223, and there is at least one processor 223 on a surface that is of one of the mainboards 222 and that faces the other mainboard 222.

Specifically, two mainboards 222 may be disposed in the server 220. The two mainboards 222 are disposed opposite to each other in the third direction Z in FIG. 22. One mainboard 222 is referred to as a first mainboard 2221, and the other mainboard 222 is referred to as a second mainboard 2222. The adapter board 227 is disposed between the first mainboard 2221 and the second mainboard 2222, and the adapter board 227 is electrically connected to both the first mainboard 2221 and the second mainboard 2222.

Specifically, FIG. 23 is a diagram of a connection of an adapter board in FIG. 22 with a first mainboard and a second mainboard. As shown in FIG. 23, there are second insertion parts J2 on both ends of the adapter board 227, and the first mainboard 2221 and the second mainboard 2222 each have a first insertion part J1. A second insertion part J2 on one end of the adapter board 227 is inserted into a first insertion part J1 on the first mainboard 2221, and a second insertion part J2 on the other end of the adapter board 227 is inserted into a first insertion part J1 on the second mainboard 2222, to electrically connect the first mainboard 2221 and the second mainboard 2222.

At least one processor 223 is disposed on each of the first mainboard 2221 and the second mainboard 2222. A processor 223 on the first mainboard 2221 is disposed on a surface that is of the first mainboard 2221 and that faces the second mainboard 2222, and a processor 223 on the second mainboard 2222 is disposed on a surface that is of the second mainboard 2222 and that faces the first mainboard 2221. Therefore, the processors 223 may occupy space between the first mainboard 2221 and the second mainboard 2222, and the server height H1 is not additionally increased.

In the structure of the server 220 shown in FIG. 13, two processors 223 located on a same mainboard 222 are interconnected by a cable on the mainboard 222, and a line layer that is used to interconnecting the processors 223 needs to be laid out on the mainboard 222. In this embodiment, two processors 223 that need to be interconnected are respectively disposed on the first mainboard 2221 and the second mainboard 2222, and a cable used to electrically connect the first mainboard 2221 and the second mainboard 2222 is laid out in the adapter board 227, to electrically connect the processor 223 on the first mainboard 2221 and the processor 223 on the second mainboard 2222. The processor 223 on the first mainboard 2221 and the processor 223 on the second mainboard 2222 may be electrically connected by the cable in the adapter board 227. Therefore, a quantity of layers of the mainboard 222 can be reduced by disposing the adapter board 227, to reduce complexity of the mainboard 222.

The memory board 224 is electrically connected to the adapter board 227. A manner in which the memory board 224 is electrically connected to the adapter board 227 is the same as the manner shown in FIG. 8. Details are not described herein again. It should be noted that in this embodiment, the memory board 224 electrically connected to the first mainboard 2221 by using the adapter board 227 is referred to as a first memory board 2241, and the memory board 224 electrically connected to the second mainboard 2222 by using the adapter board 227 is referred to as a second memory board 2242. It may be understood that the first memory board 2241 is disposed near the first mainboard 2221, and the second memory board 2242 is disposed near the second mainboard 2222, to facilitate cabling on the adapter board 227.

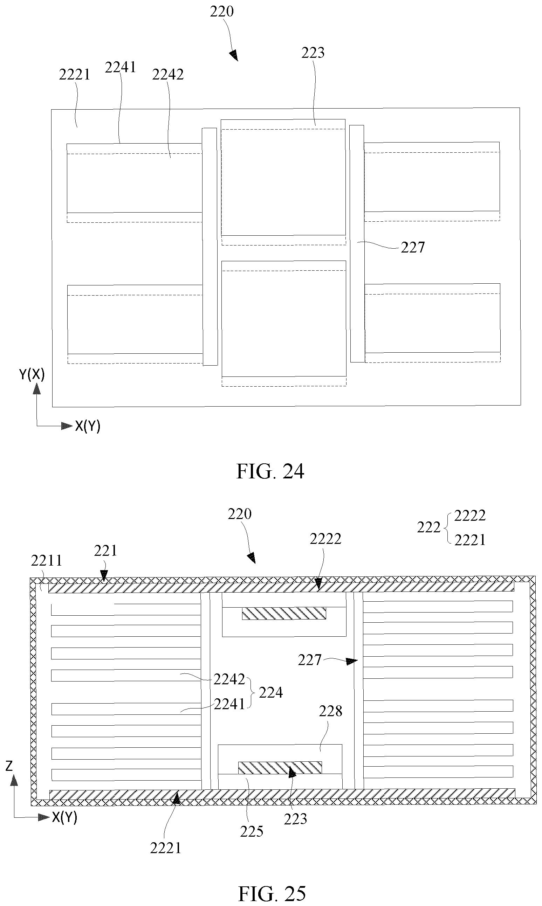

FIG. 24 is a top view of FIG. 22. For clarity, the second mainboard 2222 is removed, and the processor 223 disposed on the second mainboard 2222 and the second memory board 2242 electrically connected to the second mainboard 2222 are represented by dashed lines. As shown in FIG. 24, the processor 223 disposed on the first mainboard 2221 and the processor 223 disposed on the second mainboard 2222 may be aligned or misaligned, and the first memory board 2241 electrically connected to the first mainboard 2221 and the second memory board 2242 electrically connected to the second mainboard 2222 may be aligned or misaligned. This is specifically laid out based on design requirements of the first mainboard 2221 and the second mainboard 2222.

FIG. 25 is a schematic diagram of a seventh internal structure of the server according to an embodiment of this application. As shown in FIG. 25, based on the embodiment shown in FIG. 22, the server 220 in this embodiment further includes a housing 221. The housing 221 has an accommodating cavity 2211 for accommodating the mainboard 222, the memory board 224, the processor 223, and the adapter board 227. One of the mainboards 222 is connected to an inner bottom wall of the housing 221, and is referred to as a first mainboard 2221, and the other mainboard 222 is connected to an inner top wall of the housing 221, and is referred to as a second mainboard 2222. Other structures of the server 220 shown in FIG. 25 are the same as those of the server 220 shown in FIG. 21 and FIG. 22. Details are not described herein again.

When the first mainboard 2221 and the second mainboard 2222 are assembled, due to an assembly tolerance, a first insertion part J1 on the first mainboard 2221 and a first insertion part J1 on the second mainboard 2222 may be misaligned, a second insertion part J2 on one end of the adapter board 227 is inserted into the first insertion part J1 on the first mainboard 2221, and a second insertion part J2 on the other end of the adapter board 227 is inserted into the first insertion part J1 on the second mainboard 2222, so that the adapter board 227 is deformed.

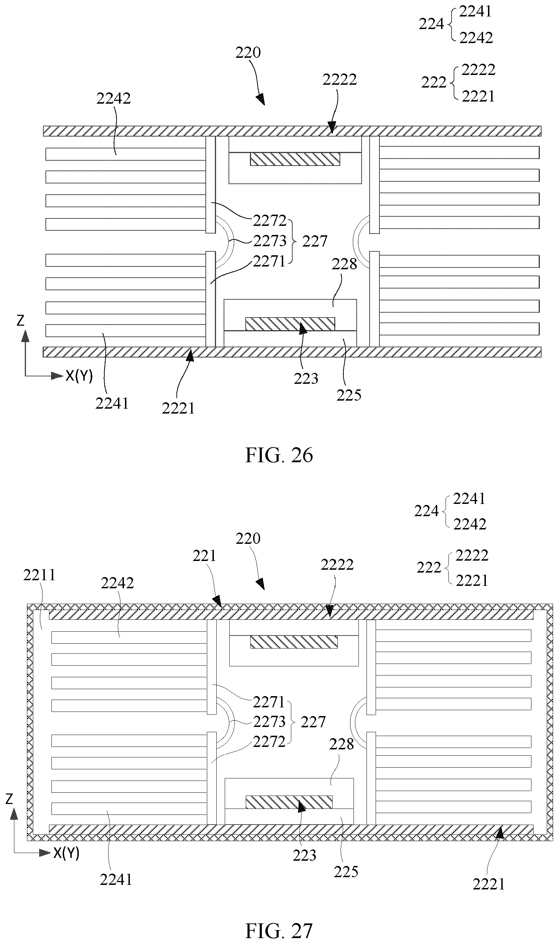

FIG. 26 is a schematic diagram of an eighth internal structure of the server according to an embodiment of this application. The foregoing problem can be resolved by using a connector 2273 shown in FIG. 26. Specifically, as shown in FIG. 26, based on the embodiments shown in FIG. 21 and FIG. 22, the server 220 further includes at least one connector 2273, there are two mainboards 222, at least one adapter board 227 is connected to each mainboard 222, and each adapter board 227 is located between the two mainboards. Quantities of adapter boards 227 on the two mainboards 222 are the same, the adapter boards 227 on the two mainboards 222 are disposed relative to each other, and the two opposite adapter boards 227 are electrically connected by using the connector 2273. There are at least two processors 223, and there is at least one processor 223 on a surface that is of one of the mainboards 222 and that faces the other mainboard 222.

An adapter board 227 electrically connected to the first mainboard 2221 is referred to as a first adapter board 2271, and an adapter board 227 electrically connected to the second mainboard 2222 is referred to as a second adapter board 2272.

The connector 2273 is configured to electrically connect the first adapter board 2271 and the second adapter board 2272. One end of the connector 2273 is electrically connected to the first adapter board 2271, and the other end of the connector 2273 is electrically connected to the second adapter board 2272. Through flexible deformation of the connector 2273, a positional deviation between the first adapter board 2271 and the second adapter board 2272 can be compensated for, so that a problem of deformation of the adapter board 227 caused by an assembly tolerance of the first mainboard 2221 and the second mainboard 2222 can be resolved.

A manner of disposing the processor 223 is the same as the disposing manner in the embodiments shown in FIG. 21 and FIG. 22. Details are not described herein again.

In this embodiment, the connector 2273 is a flexible circuit board, a flat cable, a cable, or the like.

The connector 2273 may be a flexible circuit board, and the first adapter board 2271 and the second adapter board 2272 are electrically connected by using the flexible circuit board. Specifically, there is a male connector on each end of the flexible circuit board, and there is a female connector on each of the first adapter board 2271 and the second adapter board 2272. The male connector is inserted into the female connector, so that the flexible circuit board is electrically connected to the first adapter board 2271 and the second adapter board 2272. In another implementation, there are pins on both ends of the flexible circuit board, and there are corresponding pads on the first adapter board 2271 and the second adapter board 2272. The pins are respectively welded to the pads on the first adapter board 2271 and the second adapter board 2272, so that the flexible circuit board is electrically connected to the first adapter board 2271 and the second adapter board 2272.

The connector 2273 may be alternatively a flat cable or a cable, and a manner of electrically connecting the flat cable or the cable to the first adapter board 2271 and the second adapter board 2272 is the same as that in the foregoing manner. Details are not described herein again.

FIG. 27 is a schematic diagram of a ninth internal structure of the server according to an embodiment of this application. As shown in FIG. 27, based on the embodiment shown in FIG. 26, the server 220 in this embodiment further includes a housing 221, and the housing 221 has an accommodating cavity 2211 for the mainboard 222, the memory board 224, the processor 223, and the adapter board 227. One of the mainboards 222 is connected to an inner bottom wall of the housing 221, and is referred to as a first mainboard 2221, and the other mainboard 222 is connected to an inner top wall of the housing 221, and is referred to as a second mainboard 2222. Other structures of the server 220 shown in FIG. 25 are the same as those of the server 220 shown in FIG. 21 and FIG. 22. Details are not described herein again.

It may be understood that in the embodiments shown in FIG. 21, FIG. 22, FIG. 25, FIG. 26, and FIG. 27, the server 220 may be cooled by using a cold plate or through immersion cooling. Specific manners of cooling performed by using the cold plate and immersion cooling have been described in detail in the foregoing embodiments. Details are not described herein again.

In the descriptions of the embodiments of this application, it should be noted that, unless otherwise specified or limited, terms "mount", "connected", and "connect" shall be understood in a broad sense, for example, may be a fixed connection, may be an indirect connection by using an intermediate medium, or may be communication between the inside of two elements or an interaction relationship between two elements. A person of ordinary skill in the art may understand specific meanings of the foregoing terms in the embodiments of this application based on a specific case.

In the specification, claims, and accompanying drawings of the embodiments of this application, terms "first", "second", "third", "fourth", and so on (if any) are intended to distinguish between similar objects but do not necessarily indicate a specific order or sequence.

Finally, it should be noted that the foregoing embodiments are merely intended for describing the technical solutions of the embodiments of this application, instead of limiting the embodiments of this application. Although the embodiments of this application are described in detail with reference to the foregoing embodiments, a person of ordinary skill in the art should understand that modifications may still be made to the technical solutions described in the foregoing embodiments or equivalent replacements may still be made to some or all technical features thereof. However, these modifications or replacements do not make the essence of the corresponding technical solutions depart from the scope of the technical solutions in the embodiments of this application.

## Claims

1. A server, comprising at least one mainboard, at least one adapter board, at least one processor, and at least one memory board, wherein
both the adapter board and the processor are disposed on the mainboard, the adapter board is disposed vertically or obliquely relative to the mainboard, the memory board is electrically connected to the adapter board, the adapter board is electrically connected to the mainboard, and the memory board extends from the adapter board toward an outer side of the adapter board.

2. The server according to claim 1, wherein the memory board is vertically disposed on the adapter board.

3. The server according to claim 2, wherein at least two memory boards are successively spaced apart in a height direction of the adapter board.

4. The server according to claim 2, wherein the processor is located at a middle position on the mainboard; and
the adapter board is located at a position that is on the mainboard and that is near the processor, and the memory board is located on a side that is of the adapter board and that is away from the processor; or
the adapter board is located at an edge position on the mainboard, and the memory board is located on a side that is of the adapter board and that faces the processor.

5. The server according to claim 1, wherein there are at least two adapter boards, and the adapter boards are located on different sides of the processor.

6. The server according to claim 1, wherein at least two mainboards are disposed in parallel, and at least one processor is disposed on each of opposite surfaces of the at least two mainboards.

7. The server according to any one of claims 1 to 6, wherein the at least one mainboard comprises a first mainboard and a second mainboard, and the adapter board extends from the first mainboard to the second mainboard.

8. The server according to any one of claims 1 to 6, wherein the server further comprises at least one connector, the at least one mainboard comprises a first mainboard and a second mainboard, the at least one adapter board comprises a first adapter board and a second adapter board, one end of the first adapter board is connected to the first mainboard, one end of the second adapter board is connected to the second mainboard, and the other end of the first adapter board is connected to the other end of the second adapter board by using the connector.

9. The server according to claim 8, wherein the connector is one of a flexible circuit board, a flat cable, or a cable.

10. A cabinet server, comprising a cabinet body and a plurality of servers according to any one of claims 1 to 9 that are mounted in the cabinet body.
